# EUROPEAN PATENT APPLICATION

(11) **EP 4 372 810 A1**
(43) Date of publication of application: **22.05.2024**
(21) Application number: 22208614.2
(22) Date of filing: 21.11.2022
(51) Int. Cl.: H01L 23/495, H01L 23/498

(54) **A SEMICONDUCTOR PACKAGE PROVIDING AN EVEN CURRENT DISTRIBUTION AND STRAY INDUCTANCE REDUCTION AND A SEMICONDUCTOR DEVICE MODULE**

(71) Applicant: Infineon Technologies Austria AG, 9500 Villach (AT)
(72) Inventor: SCHMOELZER, Bernd, 9545 Radenthein (AT); SCHOLZ, Wolfgang, 82140 Olching (DE); NIKITIN, Ivan, 93057 Regensburg (DE)
(74) Representative: Lambsdorff & Lange Patentanwälte Partnerschaft mbB

(57) **Abstract**

A semiconductor package (10; 20; 30) comprising a semiconductor transistor die (11), the semiconductor transistor die (11) comprising an emitter/source contact pad (11A), a drain/collector contact pad (11B), and a gate contact pad (11C), at least two electrical connectors (12, 13) which are disposed in a symmetrical manner on opposing lateral sides of the semiconductor die (11) and connected with at least one of the contact pads (11A, 11B, 11C), and an encapsulant (14) embedding the semiconductor die (11), wherein the two or more electrical connectors (12, 13) extend through the encapsulant (14) and form protruding sections above the upper surface of the encapsulant (14).

## Description

### TECHNICAL FIELD

The present disclosure is related to a semiconductor package comprising a semiconductor transistor die electrically connected so that it exhibits an even current distribution and a semiconductor device module, in particular a semiconductor device module comprising the semiconductor package.

### BACKGROUND

Over the last couple of years a lot of activities have been carried out concerning the embedding of electrical components within a package carrier system, in particular a printed circuit board (PCB). The electrical components can be active or passive components, the active components being in particular semiconductor transistor dies into the PCB or package carrier system. This solution has certain advantages such as high integration density, high reliability and high power cycling robustness. For high power applications wherein the devices are required to accommodate voltages of at least 100V and more, typically 600V, 1200V or more, embedded device technology presents unique design challenges. In particular, the high electric fields associated with power device operation make it difficult to form reliable electrical connections and adequate electrical isolation between the devices. One way to avoid these drawbacks is to embed a discrete semiconductor package within the printed circuit board. As the discrete semiconductor package is designed as a standalone component that is pre-fabricated and designed to withstand high electric fields, this avoids some of the above-mentioned issues. However, embedding a discrete semiconductor package within a printed circuit board creates particular challenges with respect to parasitic effects.

One general problem of semiconductor power transistor devices are parasitic inductances of the electrical connections between contact pads of the semiconductor transistor die and external contacts. The parasitic inductances lead to a delay in the power slew rates in the main current path between source and drain. Especially with high load currents and high temporal current changes, even parasitic inductances with values of a few nH can lead to significant voltage drops in the electrical connections. This leads directly to a limitation in performance of the device. These problems with parasitic inductances also exist with embedded power packages.

For these and other reasons there is a need for the present disclosure.

### SUMMARY

A first aspect of the present disclosure is related to a semiconductor package comprising a semiconductor transistor die, the semiconductor transistor die comprising an emitter/source contact pad, a drain/collector contact pad, and a gate contact pad, at least two electrical connectors which are disposed in a symmetrical manner on opposing lateral sides of the semiconductor die and connected with at least one of the contact pads, and an encapsulant embedding the semiconductor die, wherein the two or more electrical connectors extend through the encapsulant and emerge from it at one major surface.

A second aspect of the present disclosure is related to a semiconductor device module comprising a core layer, a first semiconductor transistor die disposed within the core layer, the first semiconductor transistor die comprising an emitter/source contact pad, a drain/collector contact pad, and a gate contact pad, wherein at least one of the contact pads is connected with two electrical connectors which are disposed in a symmetrical manner on opposing lateral sides of the semiconductor die.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.

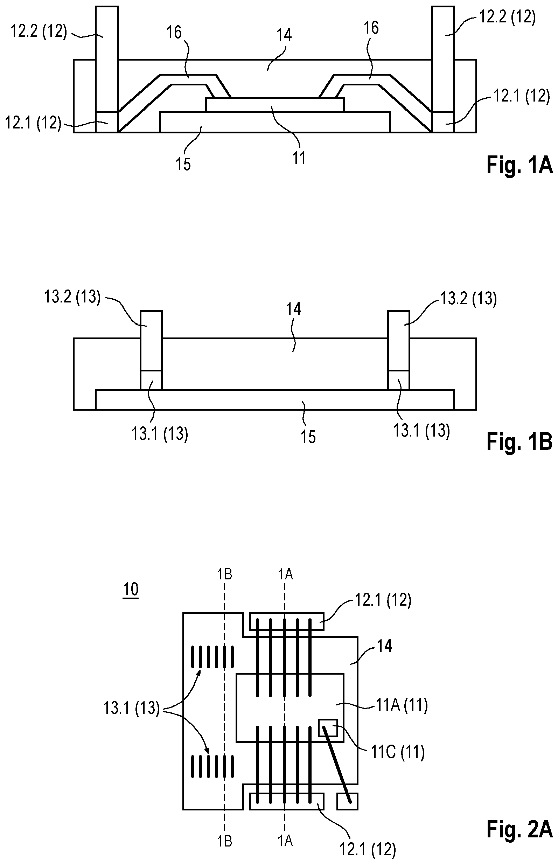

Fig. 1 comprises Fig. 1A and 1B and shows an example of a semiconductor package according to the first aspect which semiconductor package comprises symmetrically connected emitter/source pads and symmetrically connected drain/collector pads in the form of a cross-sectional view along line 1A of Fig. 2A (A) and line 1B of Fig. 2A (B).

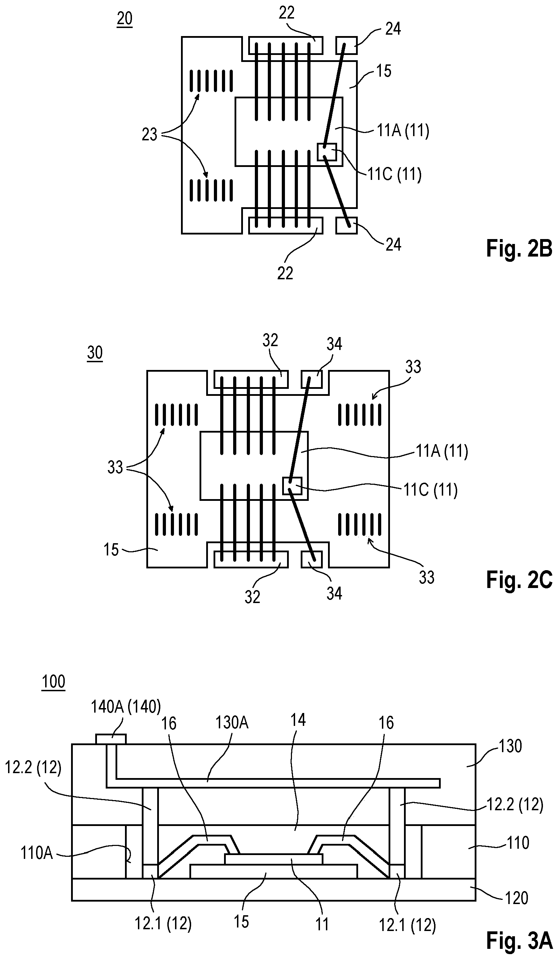

Fig. 2 comprises Figs. 2A, 2B, 2C and shows top views of examples leadframe layouts of semiconductor packages according to the first aspect, a first example with symmetrically connected emitter/source pads and symmetrically connected drain/collector pads (A), a second example with symmetrically connected emitter/source pads, symmetrically connected drain/collector pads and symmetrically connected gate pads (B), and a third example with symmetrically connected emitter/source, symmetrically connected drain/collector and symmetrically connected gate pads, the drain/collector pads being connected with four electrical connectors (C).

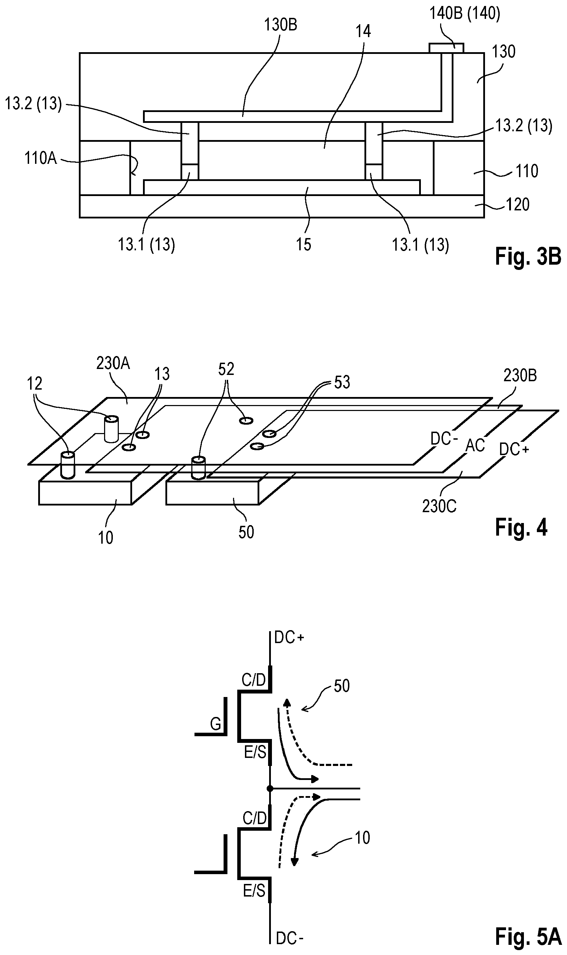

Fig. 3 comprises Fig. 3A and 3B and shows a cross-sectional side views on a semiconductor device module according to the second aspect comprising a semiconductor package of the cross-sectional views of Figs. 1A and 1B.
Fig. 4 shows a perspective view on a semiconductor device module according to the second aspect comprising two interconnected semiconductor packages according to the first aspect in which semiconductor packages the emitter pads and the collector pads are each connected with two symmetrically arranged electrical connectors, respectively.

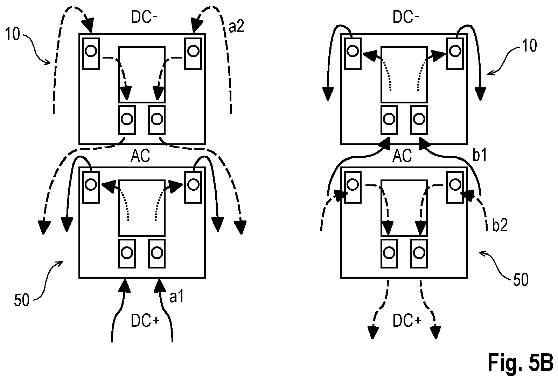

Fig. 5 comprises Fig. 5A and 5B and shows a schematic circuit representation of the semiconductor device module of Fig. 4 (A) and top views onto the semiconductor device module (B) and with arrows drawn in both Figs. to show the current flow in different switching situations.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

Fig. 1 comprises Fig. 1A and 1B and shows an example of a semiconductor package according to the first aspect in the form of a cross-sectional view along line 1A-1A of Fig. 2A (A) and line 1B-1B of Fig. 2A (B).

More specifically, as shown in Fig. 1A the semiconductor package 10 of Fig. 1 comprises a semiconductor transistor die 11, the semiconductor transistor die 11 comprising an emitter/source contact pad on an upper main surface, a drain/collector contact pad on a lower main surface, and a gate contact pad on an upper main surface (the contact pads are not shown in Figs. 1A and 1B). The semiconductor die 11 is disposed with its drain/collector pad on a metallic substrate 15. The semiconductor package 10 further comprises two first electrical connectors 12 which are connected with the emitter/source pad and disposed in a symmetrical manner on lateral opposing sides of the semiconductor die 11. More specifically, the first electrical connectors 12 may both comprise an elongated base portion 12.1 and a column portion 12.2 attached to the base portion 12.1. The connection between the emitter/source pad and the base portions 12.1 can be made by clips 16. The semiconductor package 10 of Fig. 1 further comprises an encapsulant 14 embedding the semiconductor die 11, wherein the column portions 12.2 of the first electrical connectors 12 extend through the encapsulant 14 and form protruding sections above the upper surface of the encapsulant 14.

More specifically, as shown in Fig. 1B the semiconductor package 10 of Fig. 1 further comprises two second electrical connectors 13 which are connected with the metallic substrate 15 and disposed in a symmetrical manner on lateral opposing sides of the semiconductor die 11. The second electrical connectors 13 may both comprise an elongated base portion 13.1 and a column portion 13.2 attached to the base portion 13.1. The column portions 13.2 of the second electrical connectors 13 extend through the encapsulant 14 and form protruding sections above the upper surface of the encapsulant 14.

The symmetrical arrangement of the electrical connectors on laterally opposite sides of the lead wire ensures a symmetrical distribution of the load current flowing through the transistor to the electrical connectors. As a result, the electrical connectors and the connection paths to the electrical connectors have reduced parasitic inductances compared to an asymmetrical arrangement of the electrical connectors.

As can be seen in both Figs. 1A and 1B, the second electrical connectors 13 are slightly longer than the first electrical connectors 12. The reason for this will be shown and explained later in connection with Fig. 3.

The metallic substrate 15 can, for example, be a part of a leadframe, in particular a die pad of a leadframe, wherein the leadframe may further comprise a plurality of leads which are not shown here. The leadframe may comprise an electrically conductive metal such as copper, nickel, aluminum, palladium, gold, and alloys or combinations thereof. The lead frame can be provided from a substantially uniform thickness piece of sheet metal, and the die pad and leads of the lead frame can be created by performing metal processing techniques such as stamping, punching, etching, bending, etc., on this planar sheet of metal. The leadframe can comprise a core of low-resistance metal, e.g., copper, aluminum, and one or more coatings, e.g., adhesion promotors, antioxidation coatings, etc. on an exterior surface of the lead frame. In other embodiments, the metallic substrate 15 can be another type of carrier structure comprising metallic upper surface, such as a DCB (direct bonded copper) substrate, IMS (insulated metal substrate) substrate, AMB (active metal brazed) substrate.

According to an embodiment, the semiconductor transistor die 12 includes IV semiconductor materials, e.g., silicon, silicon germanium, silicon carbide, etc., and/or type III-V semiconductor materials, e.g., gallium nitride, gallium arsenide, etc. The semiconductor transistor die 12 can be configured as a vertical device, which refers to a device that is configured to current flowing between a main surface and an opposite facing rear surface of the semiconductor die 11. In particular, the semiconductor transistor die 11 is one or more of a vertical transistor die, an IGBT die or a MOSFET die.

According to an embodiment, the semiconductor transistor die 12 is configured as a discrete power transistor. A discrete power transistor is a switching device that is rated to accommodate voltages of at least 100 V (volts) and more commonly on the order of 600 V, 1200V or more and/or is rated to accommodate currents of at least 1A (amperes) and more commonly on the order of 10A, 50A, 100A or more. Exemplary device types of discrete power transistors include MOSFETs (Metal Oxide Semiconductor Field Effect Transistors), IGBTs (Insulated Gate Bipolar Transistors), for example.

Instead of a single die configuration (as shown), the semiconductor package 100 may comprise multiple semiconductor dies 110, with each of these semiconductor dies 110 having any of the above-discussed configurations. For example, the semiconductor package 100 may comprise any one or combination of the following: a driver die integrated in combination with a power transistor die, a reverse conducting diode integrated in combination with a power transistor die, two or more power transistor dies connected in parallel with one another, and two power transistor dies connected in series with one another, e.g., to form a half-bridge circuit.

The encapsulant material of the encapsulant 14 can comprise any one or a combination of: epoxy, filled epoxy, glass fiber materials, glass fiber filled epoxy, imide, thermoplast materials, thermoset polymer, polymer blends, etc.

Fig. 2 comprises Figs. 2A, 2B, 2C and shows top views of examples of leadframe layouts of semiconductor packages according to the first aspect.

Fig. 2A shows a top view of a first example of a semiconductor package according to the first aspect with a symmetrically connected emitter/source pad and a symmetrically connected drain/collector pad.

More specifically, the semiconductor package 10 of Fig. 2A corresponds to the semiconductor package of Fig. 1 shown in another representation. The semiconductor package 10 shown in Fig. 2A comprises a semiconductor transistor die 11, the semiconductor transistor die 11 comprising an emitter/source contact pad 11A, a drain/collector contact pad, and a gate contact pad 11C. The semiconductor package 10 further comprises two first electrical connectors 12 which are connected with the emitter/source pad 11A and disposed in a symmetrical manner on opposing sides of the semiconductor die 11. The semiconductor package 10 of Fig. 2A further comprises two second electrical connectors 13 which are connected with the drain/collector pad and disposed in a symmetrical manner on opposing sides of the semiconductor die 11. The two second electrical connectors 13 are each represented here by a number of parallel lines. The semiconductor package 10 of Fig. 1A further comprises an encapsulant (not shown here) embedding the semiconductor die 11, wherein the first and second electrical connectors 12 and 13 extend through the encapsulant and form protruding sections above the upper surface of the encapsulant as was shown earlier. The semiconductor die 11 is disposed on a metallic substrate 15 like a die pad of a leadframe.

Fig. 2B shows a top view of a second example of a semiconductor package according to the first aspect with a symmetrically connected emitter/source pad, a symmetrically connected drain/collector pad, and a symmetrically connected gate pad.

More specifically, the semiconductor package 20 of Fig. 2B comprises a semiconductor transistor die 11, the semiconductor transistor die 11 comprising an emitter/source contact pad 11A, a drain/collector contact pad, and a gate contact pad 11C. The semiconductor package 20 further comprises two first electrical connectors 22 which are connected with the emitter/source pad 11A and disposed in a symmetrical manner on opposing sides of the semiconductor die 21. The semiconductor package 20 of Fig. 2B further comprises two second electrical connectors 23 - again represented as a number of parallel lines, respectively - which are connected with the drain/collector pad and disposed in a symmetrical manner on opposing sides of the semiconductor die 11. The semiconductor package 20 of Fig. 2B further comprises two third electrical connectors 24 which are connected with the gate pad 11C and disposed in a symmetrical manner on opposing sides of the semiconductor die 11. The semiconductor package 20 of Fig. 2B further comprises an encapsulant (not shown) embedding the semiconductor die 11, wherein the first, second and third electrical connectors 22, 23 and 24 extend through the encapsulant and form protruding sections above the upper surface of the encapsulant. The semiconductor die 11 is disposed on a metallic substrate 15 which can be the same as in the example of Fig. 2A.

Fig. 2C shows a top view of a third example of a semiconductor package according to the first aspect with a symmetrically connected emitter/source pad, a symmetrically connected drain/collector pad, and a symmetrically connected gate pad.

More specifically, the semiconductor package 30 of Fig. 2C comprises a semiconductor transistor die 11, the semiconductor transistor die 11 comprising an emitter/source contact pad 11A, a drain/collector contact pad, and a gate contact pad 11C. The semiconductor package 30 further comprises two first electrical connectors 32 which are connected with the emitter/source pad 11A and disposed in a symmetrical manner on opposing sides of the semiconductor die 11. The semiconductor package 30 of Fig. 2C further comprises four second electrical connectors 33 which are connected with the drain/collector pad and disposed in a symmetrical manner on opposing sides of the semiconductor die 11. The semiconductor package 30 of Fig. 2C further comprises two third electrical connectors 34 which are connected with the gate pad 31C and disposed in a symmetrical manner on opposing sides of the semiconductor die 31. The semiconductor package 30 of Fig. 2C further comprises an encapsulant (not shown) embedding the semiconductor die 31, wherein the first, second and third electrical connectors 32, 33 and 34 extend through the encapsulant and form protruding sections above the upper surface of the encapsulant. The semiconductor die 11 is disposed on a metallic substrate 25 which is different from the metallic substrates 15 of the examples of Figs. 2A and 2B. In particular, the metallic substrate 25 comprises an additional section on the right side in comparison to the metallic substrates 15, which additional section allows two additional second electrical connectors to be fitted.

Fig. 3 comprises Fig. 3A and 3B and shows a cross-sectional side views on a semiconductor device module according to the second aspect comprising a semiconductor package of the cross-sectional views of Figs. 1A and 1B.

More specifically, Fig. 3 shows a semiconductor device module 100 comprising a core layer 110, the core layer 110 comprising an opening 110A in which a semiconductor package such as that shown and described in Fig. 1 may be disposed. The core layer 110 can, for example, comprise an FR1, FR2, FR3, or FR4 material, a BT-Epoxy (where BT stands for bismaleimidtriazine), a polyimide, or a cyanate ester, glass, ceramic (AlO, SiN), and also electrically conductive materials, are conceivable as materials of the core layer 110.

The semiconductor device module 100 further comprises a first laminate layer 120 and a second laminate layer 130.

The first laminate layer 120 is applied to a lower surface of the core layer 110 and initially forms a lower boundary of the opening 110A of the core layer in the manufacturing process before the semiconductor package is then inserted into the opening 110A in a later step, wherein the semiconductor package is applied to the first laminate layer 120 with its metallic substrate 15. The second laminate layer 130 is applied to an upper surface of the core layer 110 and includes metallic layers 130A and 130B which are connected to the first and second electrical connectors 12 and 13. Thus, according to Fig. 3A, a first metallic layer 130A is connected to the electrical connectors 12, in particular to upper surfaces 12.2 of the first electrical connectors 12, and a second metallic layer 130B is connected to the second electrical connectors 13, in particular to upper surfaces of the second electrical connectors 13.

The first and second laminate layers 120 and 130 can comprise any dielectric material that is suitable for lamination such as a fiberglass or resin material. More particularly, the first and second laminate layers 120 and 130 can be layers of or comprise epoxy materials, blended epoxy and glass fiber materials such as FR-4, FR-5, CEM-4, etc., and resin materials such as bismaleimide trazine (BT) resin.

Fig. 4 shows a perspective view on a semiconductor device module according to the second aspect comprising two interconnected semiconductor packages in which semiconductor packages the emitter pads and the collector pads are each connected with two symmetrically arranged electrical connectors, respectively.

More specifically, Fig. 4 shows a semiconductor device module 200 comprising a core layer (not shown), the core layer comprising an opening in which a semiconductor package such as that shown and described in Fig. 1 may be disposed. The core layer can, for example, comprise an FR1, FR2, FR3, or FR4 material, a BT-Epoxy (where BT stands for bismaleimidtriazine), a polyimide, or a cyanate ester, glass, ceramic (AlO, SiN), and also electrically conductive materials, are conceivable as materials of the core layer.

The semiconductor device module 200 is in so far similar to the semiconductor device module 100 of Fig. 3 as it also comprises a first semiconductor package 10, which may have the same or similar properties as the semiconductor package 10 of Fig. 1 and 2A or the semiconductor packages 20 or 30 of Fig. 2B or 2C. As a difference to the semiconductor device module 100 of Fig. 1, the semiconductor device module 200 comprises a second semiconductor package 50 which comprises a second semiconductor transistor die (not shown) which is electrically connected with the first semiconductor transistor die to form, e.g., a half-bridge configuration which will be shown and explained in more detail later.

The second semiconductor package 50 can also be disposed within the core layer and it can have the same or similar structure as the first semiconductor package 10. Moreover, the second semiconductor transistor die of the second semiconductor package 50 may also comprise an emitter/source contact pad, a drain/collector contact pad, and a gate contact pad, wherein at least one, two or three of the contact pads is connected with two electrical connectors which are disposed in a symmetrical manner on lateral opposing sides of the semiconductor die. The second semiconductor die 221 may be similar or identical with the first semiconductor die 11.

In the present embodiment as shown in Fig. 4 the second semiconductor package 50 is configured so that the emitter/source and drain/collector contact pads are each connected with two electrical connectors which are disposed in a symmetrical manner on lateral opposing sides of the semiconductor die. The emitter/source pad is connected with two first electrical connectors 52 and the drain/collector is connected with two second electrical connectors 53.

The semiconductor device module 200 of Fig. 4 may also comprise an encapsulant (not shown) and both the first semiconductor package 10 and the second semiconductor package 50 can be embedded by the encapsulant.

The semiconductor device module 200 of Fig. 4 may also comprise first and second laminate layers (not shown) disposed on upper and lower surfaces of the core layer. The first and second laminate layers may have similar or identical properties as the first and second laminate layers 120 and 130 which were shown and described above in connection with Fig. 3.

In particular, the semiconductor device module 200 may also comprise metallic layers which are connected with the one, two, or three electrical connectors. In particular, the semiconductor device module 200 may comprise a first metallic layer 230A (DC-) which is connected with the first electrical connectors 12 of the first semiconductor package 10, a second metallic layer 230B (AC) which is connected with the second electrical connectors 13 of the first semiconductor package 10 and with first electrical connectors 52 of the second semiconductor package 50, and a third metallic layer 230C (DC+) which is connected with the second electrical connectors 53 of the second semiconductor package 50.

Fig. 5 comprises Fig. 5A and 5B and shows a schematic circuit representation of the semiconductor device module of Fig. 4 (A) and top views onto the semiconductor device module (B) together with arrows drawn in both Figs. to show the current flow in different switching situations.

More specifically, Fig. 5A shows a circuit diagram of a DC-AC inverter circuit. A DC-AC inverter is a device that converts a DC voltage into an AC voltage and it normally consists of four switches whereas half-bridge inverter requires two diodes and two switches which are connected in anti-parallel. The simplified example shown here consists of only two semiconductor transistor switches 10 and 50 such as those shown and described in connection with Fig. 4. The two switches 10 and 50 are complementary switches which means when a first switch 50 is ON then a second switch 10 will be OFF. Similarly, when the second switch 10 is ON the first switch 50 will be OFF.

More specifically, the views of Fig. 5 illustrate the current flow during two consecutive switching periods. The two left-hand side sub-pictures illustrate a situation in which the first switch 50 is opened by driving the gate accordingly and current flows along the direction of arrow a1 from the DC+ terminal through the IGBT of the first switch 50 from the drain/collector terminal to the emitter/source terminal in the direction of the AC node (technical current direction). In contrast, the two partial images on the right illustrate a situation in which the first switch 50 is closed and the second switch 10 is opened by controlling the gate accordingly and current flows along the direction of arrow b1 from the node AC through the IGBT of the second switch 10 from the drain/collector connection to the emitter/source connection (technical current direction).

### EXAMPLES

In the following specific Examples of the present disclosure are described.

Example 1 is semiconductor package comprising a semiconductor transistor die, the semiconductor transistor die comprising an emitter/source contact pad, a drain/collector contact pad, and a gate contact pad; at least two electrical connectors which are disposed in a symmetrical manner on opposing sides of the semiconductor die and connected with at least one of the contact pads; and an encapsulant embedding the semiconductor die, wherein the two or more electrical connectors extend through the encapsulant and form protruding sections above the upper surface of the encapsulant.

Example 2 is the semiconductor package according to Example 1, wherein two or three of the contact pads are respectively connected with two electrical connectors which are disposed in a symmetrical manner on opposing lateral sides of the semiconductor transistor die.

Example 3 is the semiconductor package according to Example 1 or 2, wherein the semiconductor die is disposed with its drain/collector pad on a metallic substrate, and the metallic substrate is connected with two electrical connectors disposed in a symmetrical manner on opposing sides of the semiconductor die.

Example 4 is the semiconductor package according to any one of the preceding Examples, wherein the at least two electrical connectors comprise metallic pillars, in particular copper pillars.

Example 5 is the semiconductor package according to any one of the preceding Examples, wherein the semiconductor transistor die is one or more of a vertical transistor die, an IGBT die or a MOSFET die.

Example 6 is a semiconductor device module comprising a core layer comprising an opening, a first semiconductor transistor die disposed within the opening, the first semiconductor transistor die comprising an emitter/source contact pad, a drain/collector contact pad, and a gate contact pad, wherein at least one of the contact pads is connected with two electrical connectors which are disposed in a symmetrical manner on opposing lateral sides of the semiconductor die.

Example 7 is the semiconductor module according to Example 6, wherein two or three of the contact pads are respectively connected with two electrical connectors which are disposed in a symmetrical manner on opposing lateral sides of the first semiconductor transistor die.

Example 8 is the semiconductor device module according to Example 6 or 7, further comprising an encapsulant embedding the first semiconductor die, wherein the two or more electrical connectors extend through the encapsulant and form protruding sections above the upper surface of the encapsulant.

Example 9 is the semiconductor device module according to Example 8, further comprising at least one metallic layer disposed within the module and connected with the at least two electrical connectors.

Example 10 is the semiconductor device module according to Example 9, further comprising two or three metallic layers disposed within the module and each one connected with one of the two electrical connectors, respectively.

Example 11 is the semiconductor device module according to Example 9 or 10, further comprising a laminate layer disposed on an upper surface of the core layer, wherein the one, two or three metallic layers are disposed within the laminate layer.

Example 12 is the semiconductor device module according to any one of Examples 6 to 9, further comprising a second transistor die electrically connected with the first semiconductor transistor die to form a half-bridge configuration.

Example 13 is the semiconductor device module according to Example 12, wherein the second semiconductor transistor die disposed within the core layer, the second semiconductor transistor die comprising an emitter/source contact pad, a drain/collector contact pad, and a gate contact pad; wherein at least one of the contact pads is connected with two electrical connectors which are disposed in a symmetrical manner on opposing sides of the semiconductor die.

Example 14 is the semiconductor device module according to Example 13, wherein two or three of the contact pads are respectively connected with two electrical connectors which are disposed in a symmetrical manner on lateral opposing sides of the first semiconductor transistor die.

Example 15 is the semiconductor device module according to any one of Examples 12 to 14, wherein the second semiconductor die is embedded by the encapsulant.

Example 16 is the semiconductor device module according to any one of Examples 6 to 15, wherein the core layer comprises a printed circuit board.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A semiconductor package (10; 20; 30), comprising
a semiconductor transistor die (11), the semiconductor transistor die (11) comprising an emitter/source contact pad (11A), a drain/collector contact pad (11B), and a gate contact pad (11C);
at least two electrical connectors (12, 13) which are disposed in a symmetrical manner on opposing sides of the semiconductor die (11) and connected with at least one of the contact pads (11A, 11B, 11C); and
an encapsulant (14) embedding the semiconductor die (11), wherein the two or more electrical connectors (12, 13) extend through the encapsulant (14) and form protruding sections above the upper surface of the encapsulant (14).

2. The semiconductor package (10; 20; 30) according to claim 1, wherein
two or three of the contact pads (11A, 11B, 11C) are respectively connected with two electrical connectors (12, 13) which are disposed in a symmetrical manner on opposing lateral sides of the semiconductor transistor die (11).

3. The semiconductor package (10; 20; 30) according to claim 1 or 2, wherein
the semiconductor die (11) is disposed with its drain/collector pad (11B) on a metallic substrate (15), and the metallic substrate (15) is connected with two electrical connectors (13) disposed in a symmetrical manner on opposing sides of the semiconductor die (11).

4. The semiconductor package (10; 20; 30) according to any one of the preceding claims, wherein
the at least two electrical connectors (12, 13) comprise metallic pillars, in particular copper pillars.

5. The semiconductor package (10; 20; 30)) according to any one of the preceding claims, wherein
the semiconductor transistor die (11) is one or more of a vertical transistor die, an IGBT die or a MOSFET die.

6. A semiconductor device module (100; 200), comprising
a core layer (110) comprising an opening (110A);
a first semiconductor transistor die (11) disposed within the opening (110A), the first semiconductor transistor die (11) comprising an emitter/source contact pad, a drain/collector contact pad, and a gate contact pad; wherein
at least one of the contact pads is connected with two electrical connectors (12, 13) which are disposed in a symmetrical manner on opposing lateral sides of the semiconductor die (11).

7. The semiconductor device module (100; 200) according to claim 6, wherein
two or three of the contact pads are respectively connected with two electrical connectors (12, 13, 14) which are disposed in a symmetrical manner on opposing lateral sides of the first semiconductor transistor die (11).

8. The semiconductor device module (100; 200) according to claim 6 or 7, further comprising
an encapsulant (14) embedding the first semiconductor die (11), wherein the two or more electrical connectors (12, 13) extend through the encapsulant (14) and form protruding sections above the upper surface of the encapsulant (14).

9. The semiconductor device module (100; 200) according to claim 8, further comprising
at least one metallic layer (130A, 130B) disposed within the module (100; 200) and connected with the at least two electrical connectors (12, 13).

10. The semiconductor device module (100; 200) according to claim 9, further comprising
two or three metallic layers (130A, 130B) disposed within the module (100; 200) and each one connected with one of the two electrical connectors (12, 13), respectively.

11. The semiconductor device module (100; 200) according to claim 9 or 10, further comprising
a laminate layer (130) disposed on an upper surface of the core layer (110), wherein the one, two or three metallic layers (130A, 130B) are disposed within the laminate layer (130) .

12. The semiconductor device module (100; 200) according to any one of claims 6 to 9, further comprising
a second transistor die electrically connected with the first semiconductor transistor die to form a half-bridge configuration.

13. The semiconductor device module (100; 200), according to claim 12, wherein
the second semiconductor transistor die (2) disposed within the core layer, the second semiconductor transistor die (2) comprising an emitter/source contact pad, a drain/collector contact pad, and a gate contact pad; wherein at least one of the contact pads is connected with two electrical connectors which are disposed in a symmetrical manner on opposing sides of the semiconductor die.

14. The semiconductor device module (100; 200) according to claim 13, wherein
two or three of the contact pads are respectively connected with two electrical connectors which are disposed in a symmetrical manner on lateral opposing sides of the first semiconductor transistor die.

15. The semiconductor device module (100; 200) according to any one of claims 12 to 14, wherein
the second semiconductor die is embedded by the encapsulant.

16. The semiconductor device module (100; 200) according to any one of claims 6 to 15, wherein
the core layer (1) comprises a printed circuit board.
